Europäisches Patentamt

European Patent Office

Office européen des brevets

(11) Publication number: **0 103 485**
**B1**

(12) **EUROPEAN PATENT SPECIFICATION**

(45) Date of publication of patent specification: **02.12.87**

(21) Application number: **83305352.3**

(22) Date of filing: **13.09.83**

(51) Int. Cl.⁴: **C 23 C 14/08,** C 23 C 14/52, G 02 B 1/10, G 02 B 5/30 // G02F1/01, G01J9/00

(54) **Processes for manufacturing double refraction plates and double refraction plates made by such processes.**

(30) Priority: **14.09.82 JP 158808/82**

(43) Date of publication of application:
**21.03.84 Bulletin 84/12**

(45) Publication of the grant of the patent:
**02.12.87 Bulletin 87/49**

(84) Designated Contracting States:
**DE FR GB NL**

(56) References cited:
CH-A- 571 068
DE-B-2 049 738
GB-A-2 075 555
US-A-4 049 338
US-A-4 068 016
US-A-4 278 710

PATENT ABSTRACTS OF JAPAN, unexamined applications, C Field, Vol. 6, No. 266, December 25, 1982 THE PATENT OFFICE JAPANESE GOVERNMENT, page 107 C 142

(73) Proprietor: **SONY CORPORATION**
**7-35 Kitashinagawa 6-Chome Shinagawa-ku Tokyo 141 (JP)**

(72) Inventor: **Mori, Toshio c/o Patent Department Sony Corporation 7-35 Kitashinagawa-6 Shinagawa-ku Tokyo (JP)**

(74) Representative: **Thomas, Christopher Hugo et al D Young & Co 10 Staple Inn London WC1V 7RD (GB)**

(56) References cited:

SOVIET INVENTIONS ILLUSTRATED, Section Ch, Week E22, July 14, 1982 DERWENT PUBLICATIONS LTD. London, L03

## 0 103 485

**Description**

This invention relates to processes for manufacturing double refraction plates.

Light impinging on certain crystals or isotropic materials placed in an electric field is refracted in two directions. This phenomenon is known as birefringence or double refraction, such crytals or materials having two discrete refractive indices. This phenomenon is related to the atomic orientation of the crystal or material and is caused to exist by actual anisotropy of the crystal material. Thus characteristics dependent on the physical properties thereof such as the rate of thermal expansion, or the electrical or thermal conductivity differ in dependence on the direction in which the measurement of these properties is made.

Light incident on a crystal plate showing these characteristics is split into two light components which propagate in two mutually perpendicular directions. If the crystal plate is a uniaxial crystal, one of the light components is refracted in the usual manner for an isotropic medium. However, the refraction of the other light component apparently does not obey the usual rule of refraction. Thus the refractive index differs with the direction of the plane of polarization. This difference in the refractive index means that the speed of the light beam depends on the direction in which it is propagating.

Double refraction plates having such characteristics are used in many optical components or devices making use of the anisotropic light propagating properties. Typical of such devices are wave plates or polarizers enclosed in an optical pick-up for optical video disc units or optical low-pass filters used in various image pick-up devices. Possibly most common are wave plates such as so-called quarter plates (1/4-wave plates) or so-called octant plates (1/8-wave plates) which are double refraction plates having the desired value of retardation and are used for modulating the plane of polarization as desired. By retardation is meant the optical path difference between linearly polarized light beams intersecting each other at a right angle.

Typical of the crystals exhibiting double refraction are quartz and calcite. Thus wave plates and polarizers are usually manufactuerd by grinding quartz to reduce its thickness. However, such grinding must be performed with great accuracy, thus raising manufacturing costs. Moreover, because of limitation in the size of the quartz or calcite available, the resulting double refraction plate, for example, is also limited in size.

In place of a double refraction plate of quartz or like material, which is both limited in size and expensive, it is also known to produce a double refraction plate by tensioning a polymer film to provide an appropriate molecular orientation. With this process, the polymer film is tensioned in a certain direction for orienting and crystallizing the molecules of the polymer film in a specific direction to create anisotropic properties of the crystal similar to those of quartz or calcite. In this manner, it has been possible to manufacture a double refraction plate having an increased size at reduced cost. However, a double refraction plate with the desired retardation is extremely difficult to manufacture from a polymer film with the required accuracy.

US patent specification US—A—4 068 016 discloses a procedure for regulating an evaporation rate and the layer build-up in the production of optically effective thin layers on a substrate, and US patent specification US—A—4 049 338 discloses a method of making a light polarizing material by impinging vapourized material onto a surface at an angle, normally between 80° and 90°, relative to a perpendicular to the surface.

According to the present invention there is provided a process for manufacturing a double refraction plate comprising the step of:

vapour-depositing a dielectric material on a surface of a substrate at an angle of at least 30° relative to a perpendicular to said surface; characterized by the further steps of:

directing polarized light through a variable phase plate onto said substrate, said polarized light having a plane of polarization in a specific direction;

observing the light reflected from said substrate through said variable phase plate, and thereby determining the retardation of the deposited double refraction film of said dielectric material being formed on said substrate; and

controlling the thickness of said deposited film in dependence upon said observation so as to achieve a desired value of said retardation.

The invention will now be described with reference to the accompanying draiwngs, in which:

Figure 1 is a schematic perspective view showing manufacture of a double refraction plate;

Figures 2A and 2B are charts showing the manner in which the retardation is caused;

Figure 3 is a side elevation showing a first deposition unit; and

Figure 4 is a side elevation showing a second deposition unit which is used in a process according to the present invention.

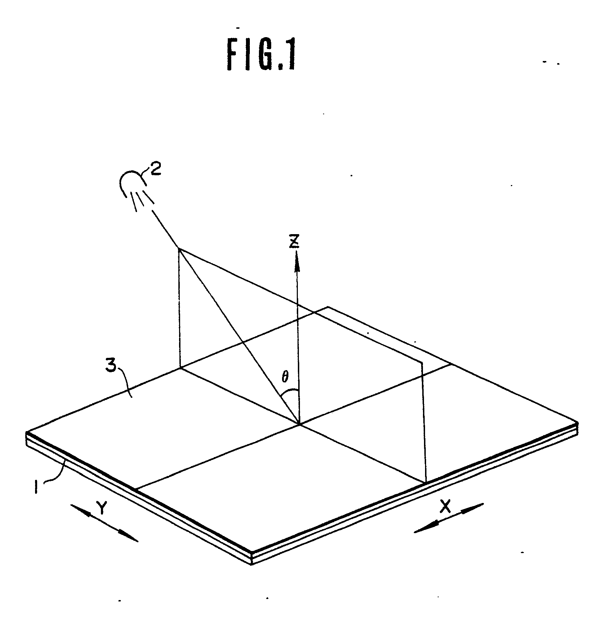

Referring to Figure 1, a dielectric material 2 is vapour-deposited on a substrate 1 at an incident angle $\theta$ to from a deposited film 3. The refractive index of the resulting film is higher in the X-axis direction than in the Y-axis direction. Light passing through the deposited film 3 is split into a linear component propagated in the X-axis direction with the lowest phase velocity and a linear component propagated in the Y-axis direction, perpendicular to the X-axis direction, with the highest phase velocity. The optical path difference between the two linear components is known as the retardation $\Gamma$, and is given by:

2

$$\Gamma = (n_x - n_y)d \qquad\qquad (1)$$

where $n_x$ and $n_y$ are refractive indices for linear components oscillating in the x and y directions, respectively, and d is the thickness of a birefringent medium, that is, the thickness of the deposited film 3.

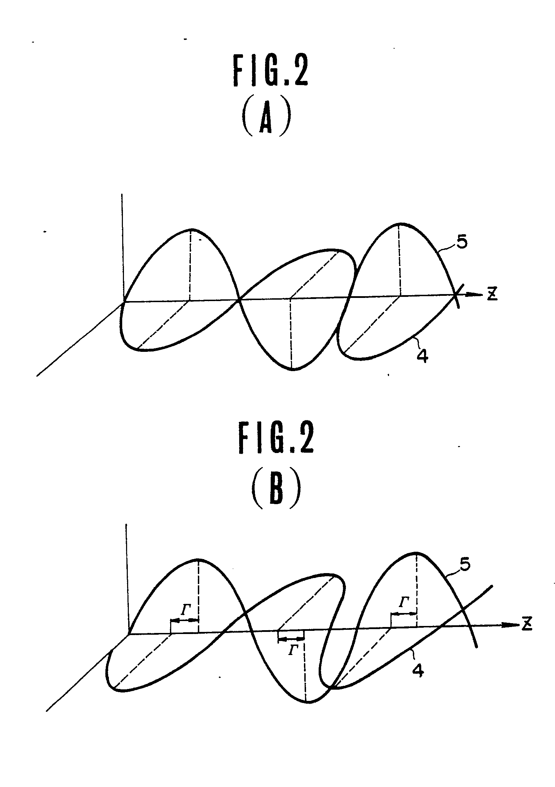

The retardation $\Gamma$ will now be further described with reference to Figures 2A and 2B. Before the light is passed through the deposited film 3, the phase of a linear component 4 in the X-axis direction is coincident with that of a linear component 5 in the Y-axis direction. However, once the light has passed through the deposited film 3, a deviation exists between the phase of the linear X-axis direction component 4 and that of the linear Y-axis direction component 5, as shown in Figure 2B. The retardation is this deviation expressed in terms of $m \times 10^{-10}$. Therefore, a double refraction plate, that is the deposited film 3 having a certain retardation, acts as a wave plate, such as a quarter plate or an octant plate, to light having a specific wavelength.

This effect of double refraction is probably caused by the fact that the direction of growth of the deposited particles is controlled due to the so-called self-shadow effect, so that the particles have more difficulty in interlinking in the Y-axis direction than in the X-axis direction perpendicular to the plane of incidence. As the interlinked particle structure is sufficiently small in size compared with the wavelength of the light, the refractive index in the X-axis direction $n_x$ is larger than that in the Y-axis direction, thus causing double refraction.

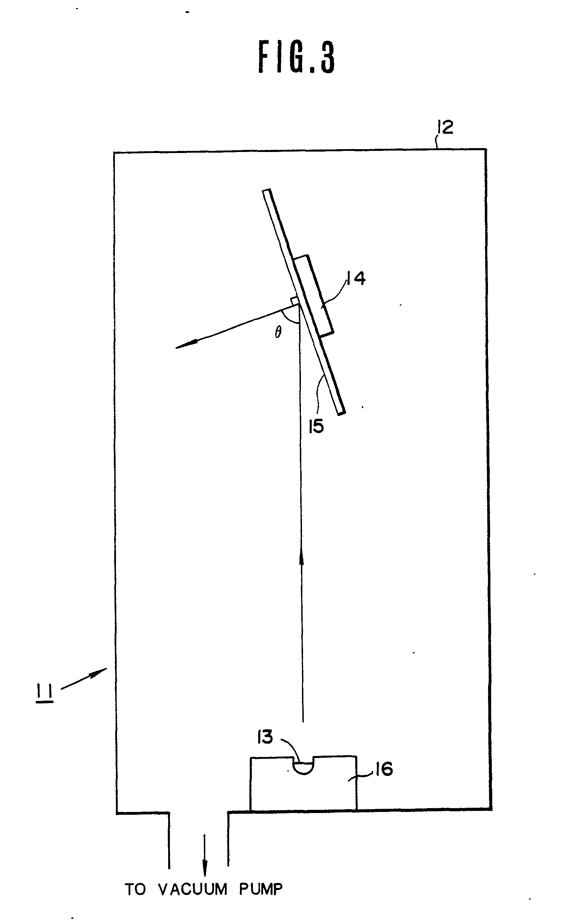

We have conducted tests in which a dielectric material is deposited from an oblique direction by using a first vapour-deposition unit 11 as shown in Figure 3, and have obtained data shown in Comparative Examples 1 to 4.

While a desired effect may be obtained with a deposition incident angle larger than 30°, for a practically useful double refraction plate an angle larger than 45° is preferred. While a desired effect may be obtained with the use of metal oxides or sulphides as the deposited material from a deposition source 13, it is thought that similar effects may be obtained by using transparent materials such as polymer materials or metal nitrides.

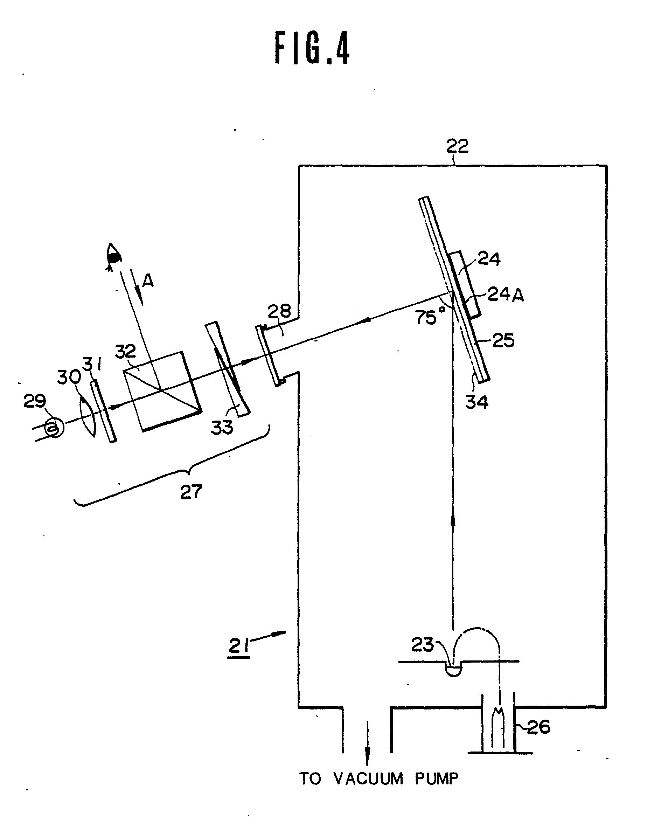

The double refraction plate obtained by the method described above is disclosed in greater detail in the following Comparative Examples 1 to 4. It should be noted that double refraction plates may be manufactured very easily with the desired shape and size by oblique deposition, that is, oblique vacuum evaporation by using the deposition unit 11 of Figure 3. In addition, by using a second vapour-deposition unit 21 as shown in Figure 4, double refraction plates of higher precision and desired retardation $\Gamma$ may be manufactured as described in the following Example 1 by a process according to the present invention, using visual inspection and monitoring of the deposition process.

Comparative Example 1

With the use of the first deposition unit 11, shown in Figure 3, titanium dioxide ($TiO_2$) forming the deposition source 13 was heated locally by an electron beam used as a heating means 16, for depositing the material.

As shown in Figure 3, this first deposition unit 11 is made up of a bell jar 12 maintained at vacuum by a vacuum pump, not shown, the deposition source 13 for depositing various materials, and a base plate mounting unit 14 orientable to any desired angle relative to the direction of the vapour produced from the deposition source 13. The heating unit 16 is associated with the deposition source 13 for vaporising various materials. The heating unit 16 may be a resistance heating unit or use an electron beam, laser beam or infrared rays for locally heating the deposition source 13, depending on the kind of deposition source 13 employed. The air in the bell jar 12 is exhausted by a vacuum pump, not shown, whereby a vacuum of less than 0.0013 pascal is maintained in the bell jar 12. A glass plate or the like substrate 15 is mounted on one surface of the mounting plate 14 and confronts the deposition source 13 at an angle θ. As the materials are vaporised by heating the deposition source 13, the vapour emitted will follow a vertical path because the inside of the bell jar 12 is maintained in vacuum, and impinges on the substrate 15 at the angle θ (deposition incident angle) relative to the perpendicular drawn to the upper surface of the substrate 15.

The film thickness d and the retardation $\Gamma$ were measured for various deposition incident angles θ with the use of a tracer type film thickness gauge and a Berek compensator.

The measured values of the deposition incident angle θ and the retardation $\Gamma$ are given in Table 1 below. In Table 1, $\Delta n$ denotes the value for $(n_x - n_y)$ calculated from the film thickness d and the retardation $\Gamma$.

**0 103 485**

TABLE 1

| Deposition incident angle ($\theta°$) | Film thickness ($\times 10^{-7}$ m) | $\Gamma$ ($\times 10^{-10}$ m) | $\Delta n$ |
|---|---|---|---|
| 0 | 7.0 | 0 | 0.000 |
| 30 | 7.2 | 109 | 0.015 |
| 45 | 5.0 | 208 | 0.041 |
| 60 | 5.1 | 270 | 0.053 |
| 70 | 4.1 | 253 | 0.062 |
| 75 | 4.0 | 320 | 0.080 |
| 80 | 2.8 | 167 | 0.059 |
| 85 | 2.5 | 72 | 0.029 |

Comparative Example 2

With the use of the first deposition unit 11, silicon monoxide (SiO) forming the deposition source 13 was heated in a tantalum boat forming the heating means 16 for depositing the material on the glass substrate 15. The values for the thickness d of the deposited film and the retardation $\Gamma$ were measured for various values of the deposition incident angle $\theta$.

The deposition incident angles $\theta$ and the measured values of the thickness d and retardation $\Gamma$ are shown in Table 2 below.

TABLE 2

| Deposition incident angle ($\theta°$) | Film thickness ($\times 10^{-7}$ m) | $\Gamma$ ($\times 10^{-10}$ m) | $\Delta n$ |
|---|---|---|---|
| 0 | 9.0 | 0 | 0.000 |
| 45 | 8.0 | 9 | 0.001 |
| 60 | 9.6 | 120 | 0.013 |
| 75 | 8.0 | 309 | 0.039 |
| 85 | 4.0 | 155 | 0.039 |

Comparative Example 3

With the use of the first deposition unit 11, silicon monoxide (SiO) forming the deposition source 13 was heated in a tantalum boat forming the heating means 16 for effecting deposition on the glass substrate 15. The various values for the film thickness d and the retardation $\Gamma$ were measured for a constant deposition incident angle $\theta$ of 75° and various temperatures Ts of the glass substrate 15.

The temperatures Ts of the glass substrate 15 and the measured values of the film thickness d and the retardation $\Gamma$ are shown in Table 3 below.

4

TABLE 3

| Ts (°C) | Film thickness ($\times 10^{-7}$ m) | $\Gamma$ ($\times 10^{-10}$ m) | $\Delta n$ |
|---|---|---|---|
| room temperature | 4.7 | 174 | 0.037 |
| 350 | 4.7 | 155 | 0.033 |
| 460 | 3.8 | 115 | 0.030 |

Comparative Example 4

Using the first deposition unit 11, various dielectric materials forming the deposition source 13 were heated by various heating means 16 for effecting deposition on the glass substrate 15. The values of the film thickness d and the retardation $\Gamma$ were measured for a constant deposition incident angle $\theta$ of 75° and various dielectric materials forming the deposition source 13.

The dielectric materials and heating means for the deposition source 13 with measured values for the film thickness d and the retardation $\Gamma$ are shown in Table 4. In this Table, Ta denotes a heating means in which the deposition source is accommodated in a tantalum boat to which a heating electric current is supplied, W a heating means in which a basketer type tungsten heater coated with alumina ($Al_2O_3$) is used for heating, and EB a heating means in which an electron beam issued for providing local heating.

TABLE 4

| Dielectric materials | Heating means | Film thickness ($\times 10^{-7}$ m) | $\Gamma$ ($\times 10^{-10}$ m) | $\Delta n$ |
|---|---|---|---|---|
| SiO | Ta | 8.0 | 309 | 0.039 |
| $Y_2O_3$ | EB | 14.0 | 155 | 0.011 |
| $TiO_2$ | EB | 9.0 | 803 | 0.089 |
| $ZrO_2$ | EB | 19.0 | 547 | 0.038 |
| $CeO_2$ | EB | 10.0 | 721 | 0.072 |
| $HfO_2$ | EB | 5.1 | 223 | 0.044 |
| $Al_2O_3$ | EB | 6.9 | 270 | 0.039 |
| $Ga_2O_3$ | EB | 6.0 | 223 | 0.037 |
| Substance-1 | EB | 11.0 | 830 | 0.075 |
| ZnS | W | 6.0 | 80 | 0.013 |

Note: Substance-1 in the above Table denotes a baked substance consisting essentially of zirconium oxide ($ZrO_2$) and zirconium titanate ($ZrTiO_4$).

Example 1

Using the second deposition unit 21, titanium dioxide as the deposition source 23 was deposited with a deposition incident angle of 75°. Thus an octant plate for light of wavelength $5600 \times 10^{-10}$ m, that is, a double refraction plate with retardation $\Gamma$ equal to $700 \times 10^{-10}$ m, was obtained.

As shown in Figure 4, the second deposition unit 21, for use in a process according to the invention is made up of a bell jar 22 from which air may be exhausted by a vacuum pump, not shown, a deposition source 23 of titanium dioxide, an electron gun 26 for heating the deposition source 23, a substrate mounting plate 24 for mounting a glass substrate 25, and a monitor unit 27. The inside of the bell jar 22 is maintained at a pressure less than 0.0013 pascal by a vacuum pump, not shown. The titanium dioxide deposition source 23 is placed at the lower end of the bell jar 22. The electron gun 26 is placed adjacent to the deposition source 23 and facing upwardly in the drawing. The electron beam from the electron gun 26 is controlled in direction by magnets, not shown, and irradiated on the deposition source 23 for heating and vaporising the deposition source 23. A glass substrate 25 is attached to one side 24A of the mounting plate 24 provided in an upper zone of the bell jar 22. The glass substrate 25 attached to the mounting plate 24 is secured so that the deposition incident angle is equal to 75°, and acts as a mirror with respect to the light beam coming from the glass substrate 25. A window 28 aligned with a perpendicular drawn to the glass substrate 25 is formed through the peripheral wall of the bell jar 22. The monitor unit 27 having said perpendicular as its optical axis is placed outside the window 28 and is made up of a light source 29, a collimator lens 30, a band-pass interference filter 31, a polarization beam splitter 32 and a variable phase plate 33.

The manufacture of a double refraction plate acting, for example, as an octant plate to light of wavelength $5600 \times 10^{-10}$ m using the second deposition unit 21, will now be described. For producing the octant plate, the band-pass interference filter 31 of the monitor unit 27 is set to a transmission wavelength of $5600 \times 10^{-10}$ m, and the variable phase plate 33 is designed as a minus octant plate ($-1/8$-wave plate). In other words, with the refractive index $n_x$ of the octant plate (1/8-wave plate) in the X-axis direction (the direction perpendicular to the plane of Figure 4) being larger than the refractive index thereof in the Y-axis direction ($n_x$ is greater than $n_y$) as in the present embodiment, the refractive index $n_x$ of the variable phase plate 33 in the X-axis direction is less than the refractive index $n_y$ thereof in the Y-axis direction, with the retardation being equal to $-700 \times 10^{-10}$ m. Thus the minus octant plate is equivalent to the octant plate rotated 90° in one or the other direction about the optical axis. In this specification, an octant plate (1/8-wave plate) is taken to be a double refraction plate having an X-axis component advanced in phase by one-eighth of a wavelength as compared with its Y-axis component. Similarly, a minus octant plate ($-1/8$-wave plate) is taken to be double refraction plate lagging in phase by one-eighth of a wavelength as compared with its Y-axis component.

When a deposited film 34 is not formed on the glass plate 25, the outgoing light from the light source 29 of the monitor unit 27 is collimated to a parallel beam by the collimator lens 30. The light is then filtered by the band-pass interference filter 31 so that only the light beam having the wavelength of $5600 \times 10^{-10}$ m is passed through the band-pass interference filter 31. The light thus filtered is split by the beam splitter 32 whereby only polarized light *a* having a specific plane of polarization is passed to the variable phase plate 33. This polarized light *a* is modulated by the variable phase plate 33 by minus one-eighth of the wavelength (thus its X-axis component lags in phase behind the Y-axis component by one eighth of the wavelength) and is reflected by the substrate mounting plate 24 to be modulated again by the variable phase plate 33 by minus one-eighth of the wavelength to form a polarized light *b*. Therefore, the polarized light *b* is modulated by minus one quarter wavelength relative to the polarized light *a*. Hence the reflected polarized light *b* is reflected at a right-angle by the beam splitter 32 thus providing a bright field of sight observed from a direction indicated by the arrow mark A.

As the deposition proceeds and the retardation $\Gamma$ of the deposited film 34 on the glass substrate 25 is equal to $-700 \times 10^{-10}$ m, the polarized light *a* is modulated by minus one-eighth of the wavelength by the variable phase plate 33. The polarized light is passed through the deposited film 34 whereby it is modulated by plus one-eighth of the wavelength and restored to the state of the polarized light *a*. This polarized light *a* is reflected by the susbtrate mounting plate 24 and again passed through the deposited film 34 whereby it is modulated by one-eighth of the wavelength and restored to the state of the polarized light *a*. The light is again transmitted through the variable phase plate 33 whereby it is modulated to minus one-eighth of the wavelength and restored to the state of the polarized light *a*. Hence the reflected light has its plane of polarization coincident with that of the polarized light *a* and thus may be transmitted through the beam splitter thus presenting a dark field of sight as viewed from the direction A.

Hence, by using the second deposition unit 21, the deposition process can be observed through the monitor unit 27 and can be terminated when the field of sight is darkest, so that the resulting deposited film 34 acts as highly accurate octant plate.

Moreover, in the above Example 1, a variety of wave plates, that is, double refraction plates having optional retardation $\Gamma$ such as a quarter plate, may be obtained by optionally changing the retardation $\Gamma$ of the variable phase plate 33.

It will be seen that deposited films having a certain degree of birefringence can be obtained making use of light transmitting materials such as metal oxides, metal sulphides, metal nitrides or metal halogenides, or high-polymeric materials. Double refraction plates having a higher retardation $\Gamma$ may be obtained by using oxides of titanium, zirconium, cerium, gallium, aluminium or silicon as the deposition source either singly or in combination. Double refraction plates with higher retardation $\Gamma$ may be obtained by using titanium dioxide.

Although the desired effect may be realised with the deposition incident angle larger than 30°, a deposition incident angle larger than 45° and preferably 75° may be used for increasing the retardation $\Gamma$ of the double refraction plate.

**Claims**

1. A process for manufacturing a double refraction plate comprising the step of:

vapour-depositing a dielectric material (23) on a surface of a substrate (25) at an angle of at least 30° relative to a perpendicular to said surface; characterized by the further steps of:

directing polarized light through a variable phase plate (33) onto said substrate (25), said polarized light having a plane of polarization in a specific direction;

observing the light reflected from said substrate (25) through said variable phase plate (33), and thereby determining the retardation of the deposited double refraction film (34) of said dielectric material (23) being formed on said substrate (25); and

controlling the thickness of said deposited film (34) in dependence upon said observation so as to achieve a desired value of said retardation.

2. A process according to claim 1 wherein said dielectric material (23) is deposited on said substrate (25) at an incident angle of more than 45°.

3. A process according to claim 1 or claim 2 wherein said dielectric material (23) is an oxide of titanium, an oxide of zirconium, an oxide of cerium, an oxide of gallium or an oxide of silicon, or a combination thereof.

4. A process according to claim 1 or claim 2, wherein said dielectric material (23) is titanium dioxide ($TiO_2$).

5. A process according to any one of the preceding claims wherein said thickness is controlled such that said retardation becomes equal to one-fourth or one-eighth of a wavelength.

**Patentansprüche**

1. Verfahren zur Herstellung einer Platte mit Doppelbrechung,

mit einem Verfahrensschritt, in dem ein dielektrisches Material (23) aus der Dampfphase auf einer Oberfläche eines Substrats (25) abgeschieden wird, wobei diese Abscheidung unter einem Winkel von wenigstens 30° relativ zu einer Senkrechten zu der genannten Oberfläche erfolgt,

gekennzeichnet durch die folgenden weiteren Verfahrensschritte:

auf das Substrat (25) wird durch eine variable Phasenplatte (33) polarisiertes Licht gerichtet, dessen Polarisationsebene in einer spezifischen Richtung verläuft,

das von dem Substrat (25) reflektierte Licht wird durch die variable Phasenplatte (33) beobachtet und dadurch die optische Gangdifferenz des abgeschiedenden doppelbrechenden Films (34) aus dielektrischem Material (23) bestimmt, der auf dem Substrat (25) ausgebildet wird,

die Dicke des abgeschiedenen Films (34) wird in Abhängigkeit von dieser Beobachtung derart gesteuert, daß sich ein gewünschter Wert der genannten optischen Gangdifferenz ergibt.

2. Verfahren nach Anspruch 1, bei dem das dielektrische Material (23) auf dem Substrat (25) unter einem Einfallswinkel von mehr als 45° abgeschieden wird.

3. Verfahren nach Anspruch 1 oder 2, bei dem das dielektrische Material (23) ein Titaniumoxid, ein Zirkoniumoxid, ein Ceroxid, ein Galliumoxid oder Siliziumoxid oder eine Kombination hieraus ist.

4. Verfahren nach Anspruch 1 oder 2, bei dem das dielektrische Material (23) Titaniumdioxid ($TiO_2$) ist.

5. Verfahren nach einem der vorhergehenden Ansprüche, bei dem die Dicke des abgeschidenen Films derart gesteuert wird, daß die optische Gangdifferenz gleich dem vierten oder dem achten Teil der Wellenlänge wird.

**Revendications**

1. Procédé de fabrication d'une lame biréfringente, comprenant l'étape de:

dépôt en phase vapeur d'un matériau diélectrique (23) sur une surface d'un substrat (25) avec un angle d'au moins 30° par rapport à une perpendiculaire à la surface,

caractérisé par les étapes supplèmentaires suivantes:

la direction de lumière polarisée à travers une lame de phase variable (33) sur le substrat (25), la lumière polarisée ayant un plan de polarisation de direction particulière,

l'observation de la lumière réfléchie par le substrat (25) à travers la lame de phase variable (33) et ainsi la détermination du retard du film biréfringent déposé (34) formé du matériau diélectrique (23) sur le substrat (25), et

le réglage de l'épaisseur du film déposé (34) d'après cette observation afin qu'une valeur voulue du retard soit obtenue.

2. Procédé selon la revendication 1, dans lequel le matériau diélectrique (23) est déposé sur le substrat (25) avec un angle d'incidence supérieur à 45°.

3. Procédé selon l'une des revendications 1 et 2, dans lequel le matériau diélectrique (23) est un oxyde de titane, un oxyde de zirconium, un oxyde de cérium, un oxyde de gallium ou un oxyde de silicium ou une combinaison de tels oxydes.

4. Procédé selon l'une des revendications 1 et 2, dans lequel le matéruau diélectrique (23) est le bioxyde de titane ($TiO_2$).

5. Procédé selon l'une quelconque des revendications précédentes, dans lequel l'épaisseur est réglée de manière que le retard devienne égal à un quart ou un huitième d'une longueur d'onde.

# FIG.1

# FIG.2
## (A)

# FIG.2
## (B)

# FIG.3

TO VACUUM PUMP

# FIG.4

TO VACUUM PUMP